# EUROPEAN PATENT APPLICATION

(11) **EP 4 462 638 A1**
(43) Date of publication of application: **13.11.2024**
(21) Application number: 23900819.6
(22) Date of filing: 17.08.2023
(51) Int. Cl.: H02J 7/34, H02J 7/00, G01R 19/165, B60L 58/18, B60L 3/00, B60L 50/60

(54) **BATTERY DEVICE AND OPERATION METHOD THEREOF**

(30) Priority: 09.12.2022 KR 20220171446
(71) Applicant: LG Energy Solution, Ltd., Seoul 07335 (KR)
(72) Inventor: KIM, Hak In, Daejeon 34122 (KR)
(74) Representative: Plasseraud IP
(86) International application number: PCT/KR2023/012194
(87) International publication number: WO 2024/122797

(57) **Abstract**

The present invention provides a battery apparatus that includes a main battery and an auxiliary battery, the battery apparatus including a control unit that determines a state of the main battery according to a wake-up signal from the auxiliary battery, and a boost charger that receives power from the auxiliary battery and charges the main battery according to the determination of the control unit, and a method of operating the same.

## Description

### TECHNICAL FIELD

The present invention relates to a battery apparatus and a method of operating the same, and more particularly, to a battery apparatus that includes a main battery and an auxiliary battery, and uses the auxiliary battery for long-term storage of the main battery of the battery apparatus, and a method of operating the same.

### BACKGROUND ART

A secondary battery capable of charging and discharging, that is, a battery, is widely used as an energy source for mobile devices such as smart phones. In addition, the battery is used as an energy source for eco-friendly vehicles such as an electric vehicle and a hybrid electric vehicle proposed as a solution to air pollution caused by a gasoline vehicle and a diesel vehicle using fossil fuels. The types of applications using the battery are becoming very diverse, and it is expected that the battery will be applied to more fields and products than now in the future.

Currently commercialized available batteries include a nickel cadmium battery, a nickel hydrogen battery, a nickel zinc battery, and a lithium ion battery. Among these batteries, the lithium ion battery is spotlighted due to their advantages of free charge and discharge, very low self-discharge rate, and high energy density because the memory effect hardly occurs compared to the nickel-based battery. In addition, since the lithium ion battery can be manufactured in a small size, the lithium ion battery is used as a power source for mobile devices, and the use range thereof has been expanded as a power source for the electric vehicle, thereby drawing attention as a next-generation energy storage medium.

Such a battery is generally used in the form of a battery pack rather than being used as a single battery cell. The battery pack includes at least one battery module, and the battery module may include a plurality of battery cells. In addition, the battery includes a battery management system (BMS) that manages overall states of the battery cell, the battery module, or the battery pack.

Meanwhile, the battery apparatus including the main battery and then auxiliary battery may be used to be applied to a power consuming apparatus. For example, the eco-friendly vehicle includes a high-voltage main battery that stores electric energy provided to an electric motor that supplies rotational force to wheels, and a low-voltage auxiliary battery that supplies power to electrical loads of the vehicle, such as headlights and wipers. That is, the battery apparatus applied to the eco-friendly vehicle may include the main battery and the auxiliary battery.

The battery apparatus including the main battery and the auxiliary battery checks a state of the main battery, such as a state of charge (SOC), by using power of the auxiliary battery for a predetermined time period when during which the battery apparatus is not in use (i.e., a predetermined time during which the main battery is set in a state of not performing a charging or discharging operation). That is, during a long time period of non-use, the BMS is woken up using the power of the auxiliary battery to measure the state of the main battery.

However, due to the nature of the lithium ion battery, energy is small at a voltage at which the SOC is lower than a predetermined level, and thus the BMS is operated in a low power mode to ensure the rechargeable time of the main battery to the maximum. However, due to the small amount of energy, the time period during which recharging can proceed is not long when the SOC is lower than the predetermined level. For example, for a 1.5 kW battery pack, the recharging time period is about 80 days. Therefore, it is desirable to set the reusable time of the expensive lithium ion battery as long as possible.

Related prior art includes the following document.

Patent document 1: KR 10-2020-0069416A

### DISCLOSURE OF THE INVENTION

### TECHNICAL PROBLEM

The present invention provides a battery apparatus including a main battery and an auxiliary battery and a method of operating the same.

The present invention provides a battery apparatus capable of increasing a reusable time period for long-term storage of a main battery by charging the main battery using power from an auxiliary battery and a method of operating the same.

The present invention provides a battery apparatus that charges the main battery to a predetermined voltage or higher by operating a boost charger using power of the auxiliary battery when a voltage of the main battery is less than or equal to a predetermined voltage during a long time period of non-use and a method of operating the same.

### TECHNICAL SOLUTION

A battery apparatus according to an aspect of the present invention is a battery apparatus that includes a main battery and an auxiliary battery, the battery apparatus including a control unit that determines a state of the main battery according to a wake-up signal from the auxiliary battery, and a boost charger that receives power from the auxiliary battery and charges the main battery according to the determination of the control unit.

The boost charger is connected to a charging and discharging path of the main battery.

After a first predetermined time elapses in a state in which the main battery does not perform charging or discharging, the control unit is switched to a sleep mode.

In the sleep mode, the control unit wakes up by periodically receiving the wake-up signal from the auxiliary battery to determine the state of the main battery.

The boost charger is operated by power of the auxiliary battery when a voltage of the main battery is equal to or less than a first set voltage.

The boost charger charges the main battery so that the voltage of the main battery is maintained at a voltage equal to or higher than a second set voltage higher than the first set voltage.

The main battery is mounted on a motor-driven apparatus to provide driving power to the motor, and the auxiliary battery provides power to electrical and/or electronic components.

A battery apparatus according to another aspect of the present invention includes a main battery, an external output path connecting an output of the main battery to an external output terminal, a control unit that determines a state of the main battery according to a periodic wake-up signal, a boost charger that is connected to the external output path and provides charging power to the external output path to charge the main battery, and an auxiliary battery that periodically generates the wake-up signal and provides driving power to the boost charger according to a voltage of the main battery.

After a predetermined time elapses in a state where the main battery does not perform charging or discharging, the control unit periodically receives the wake-up signal from the auxiliary battery to determine the state of the main battery.

The boost charger is operated by the power of the auxiliary battery when the voltage of the main battery is equal to or less than a first set voltage, and
the boost charger charges the main battery so that the voltage of the main battery is maintained at a voltage equal to or higher than a second set voltage.

The first set voltage is 2 V or less, and the second set voltage is 3 V or more.

A method of operating a battery apparatus according to still another embodiment of the present invention is a method of operating the battery apparatus that includes a main battery and an auxiliary battery, the method including a process of determining that the main battery is in a long time period of storage because the main battery does not perform charging or discharging for a predetermined time, a process of measuring a voltage of the main battery according to a wake-up signal of a predetermined period from the auxiliary battery, a process of operating a boost charger using power from the auxiliary battery when the voltage of the main battery is less than or equal to a predetermined voltage, and a process of charging the main battery by the boost charger until the voltage of the main battery reaches a predetermined voltage.

The method further includes a process of charging the main battery normally when the charger is connected, and a process of repeating the process of measuring the voltage of the main battery and subsequent processes thereof after terminating the operation of the booster charger when the charger is not connected.

### ADVANTAGEOUS EFFECTS

In the battery apparatus including the main battery and the auxiliary battery according to embodiments of the present invention, the BMS including the control unit is woken up by using power of the auxiliary battery after a predetermined time has elapsed in a state in which the main battery does not perform charging or discharging, and monitors the state of the main battery. In addition, in the present invention, when the main battery is lower than a set voltage after a predetermined time has elapsed in a state in which the main battery does not perform charging or discharging operation (i.e., when the main battery is not used for a long time), the boost charger is operated by using power of the auxiliary battery and the main battery is charged through the boost charger so that the main battery maintains a voltage equal to or higher than the set voltage. Accordingly, the voltage of the main battery can be maintained at a constant voltage for a long time when the main battery is not used for a long time and accordingly, a reusable period for long-term storage of the main battery can be increased.

### BRIEF DESCRIPTION OF THE DRAWINGS

FIG. 1 is a block diagram for describing a configuration of a battery apparatus according to an embodiment of the present invention.
FIG. 2 is a block diagram of an eco-friendly vehicle to which the battery apparatus according to the embodiment of the present invention is applied.
FIG. 3 is a flowchart for describing a method of operating the battery apparatus according to an embodiment of the present invention.

### MODE FOR CARRYING OUT THE INVENTION

Hereinafter, embodiments of the present invention will be described in detail with reference to the accompanying drawings. However, the present invention is not limited to the embodiments disclosed below, but will be implemented in a variety of different forms, and these embodiments are provided only to complete the disclosure of the present invention and to fully inform those skilled in the art of the scope of the invention.

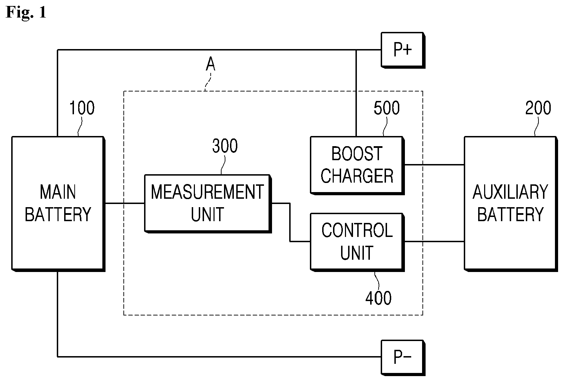

FIG. 1 is a block diagram for describing a configuration of a battery apparatus according to an embodiment of the present invention.

Referring to FIG. 1, the battery apparatus according to the embodiment of the present invention may include a main battery 100 that stores and provides first power necessary for driving a power consuming apparatus to which the battery apparatus is mounted, an auxiliary battery 200 that stores and provides a second power lower than or equal to the first power of the main battery 100, a measurement unit 300 that measures a state such as voltage of the main battery 100, a control unit 400 that wakes up according to a wake-up signal from the auxiliary battery 200 and determines the state of the main battery 100, and a boost charger 500 for charging the main battery 100 by receiving power from the auxiliary battery 200. Here, in the battery apparatus of the present invention, the BMS including the control unit 400 is switched to sleep mode after a predetermined first time during which the main battery 100 does not perform a charging or discharging operation has elapsed, and a BMS (A) including the control unit 400 is woken up using the power of the auxiliary battery in the sleep mode to monitor the state of the main battery. In addition, in the present invention, when the main battery 100 is lower than the set voltage after a predetermined second time during which the main battery is set in a state of not performing a charging or discharging operation has elapsed (i.e., when the main battery 100 is not used for a long time), the boost charger is operated using the power of the auxiliary battery 200, and the voltage of the main battery is maintained at a voltage equal to or higher than the set voltage through the boost charger. Here, the first and second times may be the same time, or the second time may be longer than the first time. In addition, the long-term non-use of the main battery 100 may be set to a time after the SOC of the main battery 100 is consumed, that is, a time after a predetermined time elapses after the SOC becomes 0%. For example, although it depends on a capacity of the main battery 100, since the main battery 100 can be completely discharged about 80 days after the SOC becomes 0%, the set time set to a time before that can be determined as the long-term non-use. In this way, when the SOC of the main battery 100 is less than or equal to a predetermined level, for example, when the SOC is 0%, the time period during which recharging can be performed may be increased. Meanwhile, the measurement unit 300, the control unit 400, and the boost charger 500 configure the BMS(A) for managing the main battery 100. That is, the measurement unit 300, the control unit 400, and the boost charger 500 may be a part of the BMS(A). The battery apparatus according to an embodiment of the present invention will be described in more detail for each configuration as follows.

### 1. Main battery

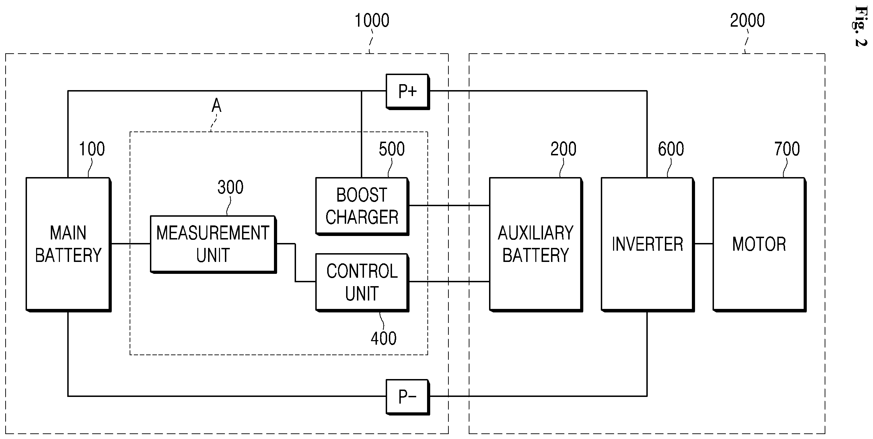

The main battery 100 is an electrical energy source that drives a power consuming apparatus. That is, the main battery 100 stores and provides first power to drive the power consuming apparatus. Here, the power consuming device may include a transportation means such as an electric scooter, an electric vehicle, or a hybrid electric vehicle. The power consuming apparatus of this embodiment may be an eco-friendly vehicle including an inverter 600 and a motor 700 as illustrated in FIG. 2, and provides power for driving the motor 700 through the inverter 600. In addition, the main battery 100 may be provided in a charging and discharging path. The charging and discharging path is a path through which the charging current and discharging current for the main battery 100 flows, and may be an electrical path connecting a positive terminal (P+) of the main battery 100 and a negative terminal (P-) of the main battery 100.

The main battery 100 may include at least one battery pack. In this case, each of the at least one battery pack may include a plurality of battery modules, and each of the battery modules may include a plurality of battery cells capable of being charged and discharged. That is, the main battery 100 includes the plurality of battery cells, and the plurality of battery cells may be bundled in a predetermined unit to form the battery module, or the plurality of battery modules may form one battery pack. Meanwhile, the plurality of battery cells may be connected in series and/or in parallel in various ways to meet specifications of the power consuming device. Of course, a plurality of battery packs each including a plurality of battery cells may also be connected in series and/or in parallel. Here, the type of battery cell is not particularly limited, and may include, for example, a lithium ion battery, a lithium polymer battery, a nickel cadmium battery, a nickel hydride battery, a nickel zinc battery, etc.

### 2. Auxiliary battery

The auxiliary battery 200 stores and provides second power lower than the first power of the main battery 100. That is, the auxiliary battery 200 may have a voltage and a current lower than that of the main battery 100. For example, the auxiliary battery 200 may have a voltage of 14 V and a current of 6 Ah. In the case of an eco-friendly vehicle, the auxiliary battery 200 does not provide power for driving the eco-friendly vehicle, but provides power necessary for peripheral parts of the eco-friendly vehicle. That is, the auxiliary battery 200 does not provide power for driving the motor 700 but provides power for driving various electrical and/or electronic components. In addition, the auxiliary battery 200 of the present invention functions to wake up the BMS(A) by supplying a wake-up signal. That is, after a predetermined time during which the main battery is set in a state of not performing a charging or discharging operation has elapsed, the BMS(A) including the control unit 400 is woken up using the power of the auxiliary battery 200 to monitor the main battery 100. In addition, when the voltage of the main battery 100 which is woken up is lower than the the set voltage, the auxiliary battery 200 provides power for operating the boost charger 500. The boost charger 500 is operated by the power of the auxiliary battery 200 to charge the main battery 100, and accordingly, the main battery 100 maintains a voltage equal to or higher than the set voltage.

The auxiliary battery 200 may be mounted on an eco-friendly vehicle. That is, the battery apparatus of the present invention may be configured by connecting the battery apparatus including the main battery 100 and the BMS to the auxiliary battery 200 mounted on the eco-friendly vehicle. This auxiliary battery 200 may be capable of charging and discharging. In this case, the auxiliary battery 200 may be charged by regenerative power generation of the eco-friendly vehicle, or may be charged by an external charging device together with the main battery 100. Like the main battery 100, the auxiliary battery 200 may include a plurality of battery cells and may be a lithium-based battery cell. That is, the auxiliary battery 200 is configured in the form of the battery pack in which a plurality of chargeable and dischargeable battery cells are connected in series or in parallel, and may include a plurality of such battery packs. Of course, unlike the main battery 100, the auxiliary battery 200 may be made of, for example, a lead acid battery.

### 3. Measurement unit

The measurement unit 300 may be provided to measure a state of the main battery 100. For example, the measurement unit 300 may measure the current, voltage, temperature, etc. of the main battery 100. In addition, the measurement unit 300 may measure states such as the current and voltage of the battery pack, battery module, and battery cell. That is, the measurement unit 300 may measure a state of each of the plurality of battery cells, a state of the battery module in which the plurality of battery cells are bundled, or a state of the battery pack in which the plurality of battery modules are bundled. To this end, the measurement unit 300 may include a plurality of sensors. That is, the measurement unit 300 may include at least one current sensor, at least one voltage sensor, and at least one temperature sensor. The current sensor, voltage sensor, and temperature sensor may periodically measure the current, voltage, and temperature of the main battery 100 and provide the measurement results to the control unit 400. Here, the voltage sensor generates a signal corresponding to the voltage applied between the positive electrode and the negative electrode of the main battery 100 and provides the signal to the control unit 400. As an example, the voltage sensor may include a differential amplifier circuit outputting a voltage signal corresponding to a voltage difference between the positive and negative terminals of the main battery 100. In addition, the current sensor is a sense resistor or a hall sensor, and generates a signal corresponding to the magnitude of the charging current and provides the signal to the control unit 400. The current sensor can measure not only the magnitude of the charging current but also the magnitude of the discharging current. The temperature sensor may be, for example, a thermos-coupler used to measure temperature. The temperature sensor generates a signal corresponding to the temperature of the main battery 100 and provides the signal to the control unit 400.

### 4. Control unit

The control unit 400 controls charging and discharging of the main battery 100 by controlling a charge and discharge switch (not illustrated) depending on the voltage of the main battery 100. In addition, the control unit 400 of the present invention switches the BMS(A) to a sleep mode when the main battery 100 does not charge and discharge for a set time. In this state of being switched to the sleep mode, the control unit 400 is woken up by the power of the auxiliary battery 200. That is, the auxiliary battery 200 provides the wake-up signal at predetermined cycles, and accordingly, the control unit 400 is waken up to monitor the main battery 100. In this case, the measurement unit 300 is also woken up by the auxiliary battery 200 to measure the state of the main battery 100, and at least the voltage sensor of the measurement unit 300 is woken up to measure the voltage of the main battery 100. In addition, the control unit 400 controls the main battery 100 to be charged using the auxiliary battery 200 when the voltage of the main battery 100 is equal to or less than the set voltage. That is, when the voltage of the main battery 100 is, for example, 2 V or less, the control unit 400 applies a control signal to the auxiliary battery 200 so that the auxiliary battery 200 can drive the boost charger 500.

### 5. Boost charger

The boost charger 500 may be provided on the charging and discharging path of the main battery 100 to charge the main battery 100. The boost charger 500 receives a predetermined voltage from the auxiliary battery 200 and generates a voltage for charging the main battery 100. That is, the boost charger 500 receives a predetermined voltage supplied from the auxiliary battery 200, generates a predetermined voltage using the supplied voltage and supplies the generated predetermined voltage to the main battery 100, thereby allowing the main battery 100 to be charged to a predetermined voltage. For example, the boost charger 500 receives a voltage of 14 V from the auxiliary battery 200, boosts the voltage to 42 V, and charges the main battery 100 until the main battery 100 reaches 3 V.

As described above, in the battery apparatus including the main battery 100 and the auxiliary battery 200 according to an embodiment of the present invention, the BMS including the control unit 400 is woken up by using power of the auxiliary battery 200 after a predetermined first time during which the main battery is set in a state of not performing a charging or discharging operation has elapsed, and monitors the state of the main battery. In addition, in the present invention, when the main battery 100 is lower than a set voltage after a predetermined second time during which the main battery is set in a state of not performing a charging or discharging operation has elapsed (i.e., when the main battery 100 is not used for a long time), the boost charger is operated using power of the auxiliary battery 200 and the main battery is charged through the boost charger so that the main battery maintains a voltage equal to or higher than the set voltage. For example, when the voltage of the main battery 100 is 2 V or less, the boost charger 500 is operated using the power of the auxiliary battery 200 so that the main battery 100 maintains the voltage of 3 V or more. Accordingly, the voltage of the main battery 100 can be maintained at a constant voltage for a long time when the main battery 100 is not used for a long time, and accordingly, the reusable period for long-term storage of the main battery can be increased.

[Table 1] shows a comparison of a reuse period between a conventional case and the present invention. That is, [Table 1] shows the present invention in which the main battery is charged by operating the boost charger using the auxiliary battery and the conventional case for not charging the main battery by operating the boost charger. Here, the auxiliary battery applied to the present invention has a chargeable capacity of 1600 mAh when considering an efficiency of 80% with a voltage of 14 V and an amount of electricity of 6 Ah.

**[Table 1]**

| classification | SOC 0%∼2.3V(sleep mode) | | 2.3V∼2.0V(shut down mode) | | Total |
|---|---|---|---|---|---|
| | remaining capacity (mAh) | period (day) | remaining capacity (mAh) | period (day) | |
| conventional one | 441 | 36.55 | 121.0 | 45.5 | 82.01 |
| the present invention | 441 + 1235 = 1696 | 138.4 | 121 + 344 = 465 | 171.6 | 310 |

As shown in [Table 1], in the sleep mode, in the conventional case, the capacity is 441 mAh, but the capacity greatly increases to 1696 mAh in the present invention, and in the conventional case, the reusable time period is 36.55 days, but greatly increases to 138.4 days in the present invention. In the shutdown mode, in the conventional case, the capacity is 121 mAh, but increases to 465 mAh in the present invention, and in the conventional case, the reuse time period is 45.5 days, but greatly increases to 171.6 days in the present invention. As a result, it can be seen that the total reuse time period is about 82 days in the conventional case, but greatly increases to 310 days in the present invention.

The battery apparatus according to one embodiment of the present invention can be applied to an eco-friendly vehicle including the inverter 600 and the motor 700 as illustrated in FIG. 2. That is, as illustrated in FIG. 2, the main battery 100, the measurement unit 200, the control unit 400, and the boost charger 500 configure a main battery apparatus 1000, and the main battery apparatus 1000 may be applied to an eco-friendly vehicle 2000 including the auxiliary battery 200, the inverter 600 and the motor 700. In this case, in the main battery apparatus 1000 applied to the eco-friendly vehicle, the control unit 400 and the boost charger 500 may be connected to the auxiliary battery 200. Accordingly, the control unit 400 may be woken up by the auxiliary battery 200 at predetermined intervals, and the boost charger 500 may be operated by the auxiliary battery 200. Respective components configuring the eco-friendly vehicle will be described in more detail below.

### 6. Inverter

The inverter 600 drives the motor 700 so that the eco-friendly vehicle can be driven. That is, the inverter 600 converts DC power of the main battery 100 into AC power to be used for the motor 700, maintains accurate charging, and influences rotational speed and torque control of the motor 700. Of course, an eco-friendly car using the DC motor does not need the inverter, but an inverter capable of freely changing frequency, voltage, number of revolutions, and torque is absolutely necessary in order to use a high-performance AC motor.

### 7. Motor

The motor 700 may provide driving force to the eco-friendly vehicle. That is, the motor 700 may provide wheel driving force so as to move the eco-friendly vehicle by using energy supplied from the main battery 100 through the inverter 600. The motor 700 may be configured with, for example, at least one of an induction motor, a permanent magnet synchronous motor, and a reluctance motor. Meanwhile, the eco-friendly vehicle may further include a motor controller for controlling the motor 700. The motor controller detects an accelerator pedal operation amount and speed and controls the torque and rotation speed of the motor 700 according to conditions such as vehicle speed and load so as to bring about the intended torque change from the detected accelerator pedal operation amount and speed. In a DC motor, current controls torque and voltage controls speed, and in an AC motor, amplitude controls torque and frequency controls speed.

Meanwhile, although not illustrated, the eco-friendly vehicle may further include a regenerative power generation device. The regenerative power generation device may be provided to reduce energy consumption of the eco-friendly vehicle. In the eco-friendly vehicle, the motor 700 has the same structure as a generator, and thus the motor 700 rotates when current flows, and on the contrary, the motor 700 becomes a generator when it rotates by applying force from the outside. When the eco-friendly vehicle is decelerated by operating the brake while driving, inertial force to continue driving is generated in the vehicle, and thus the motor 700 is operated as a generator by being reversely driven by the inertial force to generate electricity, which is called regenerative power generation. In addition, when braking the vehicle, a portion of the braking force may be used to generate electricity, and the generated electrical energy may be charged in the main battery 100 and/or the auxiliary battery 200.

In addition, electrical and/or electronic components driven by the auxiliary battery 200 may include electrical and electronic parts driven by electricity among parts configuring the eco-friendly vehicle. For example, the electrical and/or electronic components may include lights required for driving, lighting system, an instrumentation device (cluster) that comprehensively provides information necessary for driving and operation, an airbag system that protects the occupant's body in the event of a collision, a body control system (BCS) that provides various driving convenience and information to the driver, an AQS system that automatically purifies the interior air of the vehicle, an automatic air conditioning control system that automatically controls the temperature and humidity inside the vehicle, a back warning system (BWS) that identifies and warns a rear object when reversing, etc. In addition, various electrical and/or electronic components may include a security system to prevent vehicle theft or a before service warning system (BSWS) that detects the state of the vehicle and provides preventive maintenance information to the driver, etc. may be included as examples.

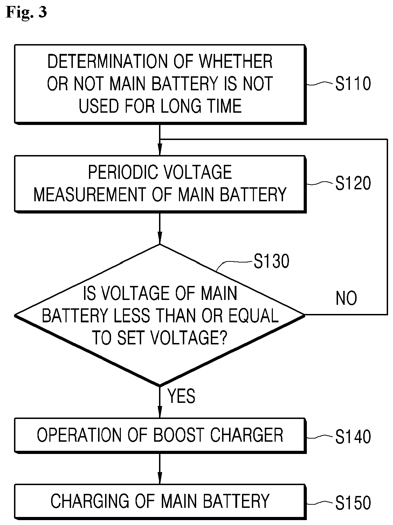

FIG. 3 is a flowchart for describing a method of operating the battery apparatus including the main battery and the auxiliary battery according to an embodiment of the present invention.

Referring to FIG. 3, the method of operating the battery apparatus according to an embodiment of the present invention may include determining that is in a long time period of storage)because the main battery does not perform charging or discharging for a predetermined time (S110), measuring the voltage of the main battery according to the wake-up signal of the auxiliary battery at predetermined intervals (S 120), determining whether the voltage of the main battery is less than or equal to a predetermined voltage (S 130), operating a boost charger using power from the auxiliary battery when the voltage of the main battery is less than or equal to the predetermined voltage,; and charging the main battery by the boost charger until the voltage of the main battery reaches a predetermined voltage (S 150). Thereafter, if the charger is connected, the main battery is normally charged, and if the charger is not connected, the operation of the booster charger is terminated and the process is repeated from S 110. The method for operating the battery apparatus according to the embodiment of the present invention will be described in more detail for each step as follows.

S 110: In the battery apparatus of the present invention, the BMS including the control unit 400 is switched to sleep mode after a predetermined time during which the main battery 100 does not perform a charging or discharging operation has elapsed, and the BMS(A) including the control unit 400 is woken up using the power of the auxiliary battery in the sleep mode to monitor the state of the main battery. In addition, in the present invention, it may be determined that the main battery 100 is not used for a long time after a predetermined second time during which the main battery 100 is set in a state of not performing a charging or discharging operation has elapsed. In this case, the long-term non-use of the main battery 100 may be set to a time after the SOC of the main battery 100 is consumed, that is, after the SOC becomes 0% and a predetermined time elapses. For example, although it depends on the capacity of the main battery 100, since the main battery 100 is completely discharged about 80 days after the SOC becomes 0%, the set time to a time before that, for example, any one of 1 to 70 days, can be determined as the long-term non-use.

S120: Even after the main battery 100 is determined as the long-term non-use, the BMS is woken up according to the wake-up signal from the auxiliary battery 200 to measure the voltage of the main battery 100. The wake-up signal of the auxiliary battery 200 may be generated at a set cycle, and accordingly, the BMS may be woken up every set cycle. When the BMS is woken up, the voltage sensor of the measurement unit 300 measures the voltage of the main battery 100 and transfers the measured value to the control unit 400.

S130: The control unit 400 receives the measured voltage value from the measurement unit 300 during wake-up and determines whether the voltage is lower than the set voltage. For example, the control unit 400 determines whether the voltage of the main battery 100 is 2V or less. As a result of the determination, when the voltage of the main battery 100 is more than 2V, the measuring of the voltage of the main battery 100 according to the wake-up signal of the auxiliary battery 200 S 120 is repeated every predetermined cycle.

S140: When it is determined that the voltage of the main battery 100 is 2V or less, the control unit 400 controls the auxiliary battery 200 to operate the boost charger 500. That is, the auxiliary battery 200 provides a voltage for operating the boost charger 500, for example, a voltage of 14 V to the boost charger 500, and the boost charger 500 uses the voltage to generate a voltage for charging the main battery 100, for example, a voltage of 42 V.

S150: The boost voltage generated from the boost charger 500 by the auxiliary battery 200 is provided to the main battery 100 to charge the main battery 100. For example, the boost charger 500 supplies the boost voltage of 42 V to the main battery 100 to charge the main battery 100. While the main battery 100 is being charged, the measurement unit 200 measures the voltage of the main battery 100, and when the voltage of the main battery 100 reaches a set voltage, for example, a voltage of 3 V, the control unit 400 controls the auxiliary battery 200 to stop the operation of the boost charger 500 by stopping the power supplied to the boost charger 500. That is, the boost charger 500 charges the main battery 100 using the power of the auxiliary battery 200 until the main battery 100 reaches the set voltage of, for example, 3 V.

After that, if the charger is connected, the main battery 100 is normally charged, and if the charger is not connected, the process is repeated from step 120.

Although the technical idea of the present invention as described above has been specifically described according to the embodiment described above, it should be noted that the embodiment described above is for explanation thereof and not for limitation. In addition, those skilled in the art will understand that various embodiments are possible within the scope of the technical idea of the present invention.

## Claims

1. A battery apparatus that includes a main battery and an auxiliary battery, the battery apparatus comprising:
a control unit that determines a state of the main battery according to a wake-up signal from the auxiliary battery; and
a boost charger that receives power from the auxiliary battery and charges the main battery according to the determination of the control unit.

2. The battery apparatus of claim 1, wherein
the boost charger is connected to a charging and discharging path of the main battery.

3. The battery apparatus of claim 2, wherein
after a first predetermined time elapses in a state in which the main battery does not perform charging or discharging, the control unit is switched to a sleep mode.

4. The battery apparatus of claim 3, wherein
in the sleep mode, the control unit wakes up by periodically receiving the wake-up signal from the auxiliary battery to determine the state of the main battery.

5. The battery apparatus of claim 4, wherein
the boost charger is operated by power of the auxiliary battery when a voltage of the main battery is equal to or less than a first set voltage.

6. The battery apparatus of claim 5, wherein
the boost charger charges the main battery so that voltage of the main battery is maintained at a voltage equal to or higher than a second set voltage higher than the first set voltage.

7. The battery apparatus of any one of claims 1 to 6, wherein
the main battery is mounted on a motor-driven apparatus to provide driving power to a motor, and the auxiliary battery provides power to electrical and/or electronic components.

8. A battery apparatus comprising:
a main battery;
an external output path connecting an output of the main battery to an external output terminal;
a control unit that determines a state of the main battery according to a periodic wake-up signal;
a boost charger that is connected to the external output path and provides charging power to the external output path to charge the main battery; and
an auxiliary battery that periodically generates the wake-up signal and provides driving power to the boost charger according to a voltage of the main battery.

9. The battery apparatus of claim 8, wherein
after a predetermined time elapses in a state where the main battery does not perform charging or discharging, the control unit periodically receives the wake-up signal from the auxiliary battery to determine the state of the main battery.

10. The battery apparatus of claim 9, wherein
the boost charger is operated by the power of the auxiliary battery when the voltage of the main battery is equal to or less than a first set voltage, and
the boost charger charges the main battery so that the voltage of the main battery is maintained at a voltage equal to or higher than a second set voltage.

11. The battery apparatus of claim 11, wherein
the first set voltage is 2 V or less, and the second set voltage is 3 V or more.

12. A method of operating a battery apparatus that includes a main battery and an auxiliary battery, the method comprising:
determining that the main battery is in a long time period of storage because the main battery does not perform charging or discharging for a predetermined period of time;
measuring a voltage of the main battery according to a wake-up signal of a predetermined period from the auxiliary battery;
operating a boost charger using power from the auxiliary battery when the voltage of the main battery is less than or equal to a predetermined voltage; and
charging the main battery by the boost charger until the voltage of the main battery reaches a predetermined voltage.

13. The method of claim 12, further comprising:
charging the main battery normally when a charger is connected; and
repeating the measuring the voltage of the main battery and subsequent steps thereof after terminating the operation of the booster charger when the charger is not connected.
